# EUROPEAN PATENT APPLICATION

(11) **EP 2 833 155 A1**
(43) Date of publication of application: **04.02.2015**
(21) Application number: 13003801.1
(22) Date of filing: 30.07.2013
(51) Int. Cl.: G01R 15/18, G01R 35/02

(54) **Current and/or voltage sensing device with phase error compensation**

(71) Applicant: ABB Technology AG, 8050 Zürich (CH)
(72) Inventor: Podzemny, Jaromir, 621 00 Brno (CZ); Pavlas, Marek, 68354 Otnice (CZ); Velesik, Petr, 602 00 Brno (CZ)
(74) Representative: Schmidt, Karl Michael

(57) **Abstract**

The invention relates to Current and/or voltage sensing device (1) with primary and secondary circuits, for medium and/or high voltage AC - power grids, with design features, in order to cause a compensation of phase error and/or phase displacement and/or phase shift in the device. In order to realize a phase error compensation, the phase displacement/error/shift is improved or minimized by impedance matching element (6), which is connected to and/or within the secondary circuit of the current and/or voltage sensing device.

## Description

The invention relates to current and/or voltage sensing device with primary and secondary circuits, for medium and/or high voltage AC - power grids, with design features, in order to cause a compensation of phase error and/or phase displacement and/or phase shift in the current and/or voltage sensing device, according to the preamble of claim 1.

The phase error of medium voltage instrument transformers in the sense of the a.m. current and/or voltage sensing device for AC-power grids, is definded by transformer design and construction of internal parts and material used. In case the phase displacement for phase error is outside permitted limits, design of internal parts has to be changed in order to meet given limits. This results in customized design, several different construction variants and higher production effort, which is a great disadvantage.

So it is the object of the invention, to realize a phase error compensation for current and/or voltage sensing device, which is much easier to design with lower constructional expense.

This object results in the invention as follows.

The invention is, that the phase displacement/error/shift is improved or minimized by impedance matching element (6), which is connected to and/or within the secondary circuit of the current and/or voltage sensing device.

In an advantageous embodiment the impedance matching element is located in a secondary terminal box of the current and/or voltage sensing device, wherein the shielding of the terminal box is realized by a cover layer in order to reduce external disturbances.

In a further advantageous embodiment, the impedance matching element is located in the sensing device body and/or implemented into the connecting cable, wherein the shielding of the impedance matching element is realized by a cover layer in order to reduce external disturbances.

An advantageous embodiment is, that the material of the cover layer is made of conductive or semiconductive material with sufficient resistance to external electrical and/or magnetic disturbances.

An alternative embodiment is, that the material of the cover layer is made of insulating material, in case the outer environment has sufficient shielding effectiveness or the use disable the possibility for significant disturbances.

A last advantageous embodiment is, that the impedance matching element contain at least one capacitor or at least one inductor.

The invention is shown in principle in the figures.
Figure 1: matching element in the evaluating unit
Figure 2: State of the art

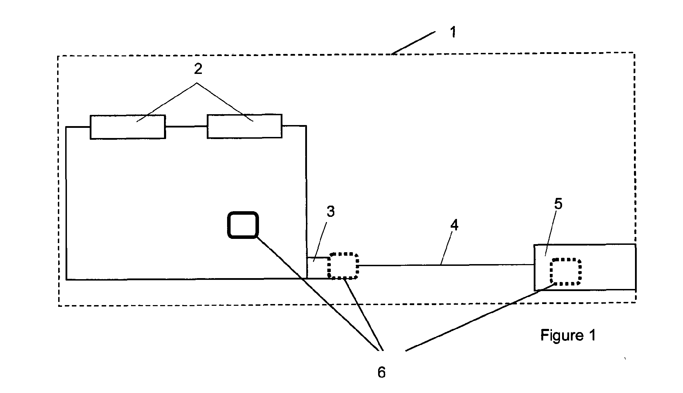

Figure 1 shows a matching element located in or near the evaluating unit. In all cases this phase matching element is a part of the sensor.
Figure 1 therefore shows possible placement of impedance matching element 6.

A Current and/or voltage sensing device 1 contains from main body, primary terminal/terminals 2 and secondary terminals 3. For interconnection with an evaluating unit 5 the cable or wires 4 are used. In order to improve the aforesaid phase displacement/error of current and/or voltage sensing device the special impedance matching element 6 is implemented directly into the sensing circuit.

In this embodiment, it is located in or close to the evaluating unit.
So the phase matching element is inserted, that means located at the end of the cable wires 4.

In case of sensors with long cables, it is known, that this long cable causes some capacitance, which would cause the phase error. By the invention the aforesaid phase matching element is a capacitor, inductor or a RLC circuit, which will cause the phasors of measured quantity, to be in line with phasors of output signal, thus having zero phase displacement. One or more capacitors and/or inductors could be used within said impedance matching element.

Phase displacement is one of the two important factors (amplitude + phase error) deciding about accuracy class, so imporving the phase displacement can help in achieving better accuracy class.
This function is practicable for both sensor types, current sensors and voltage sensors. According to the invention these matching elements are used and placed in the sensore device, which are delivered with cables and placed such element at the end of the cable or within the connector boot of the cables.

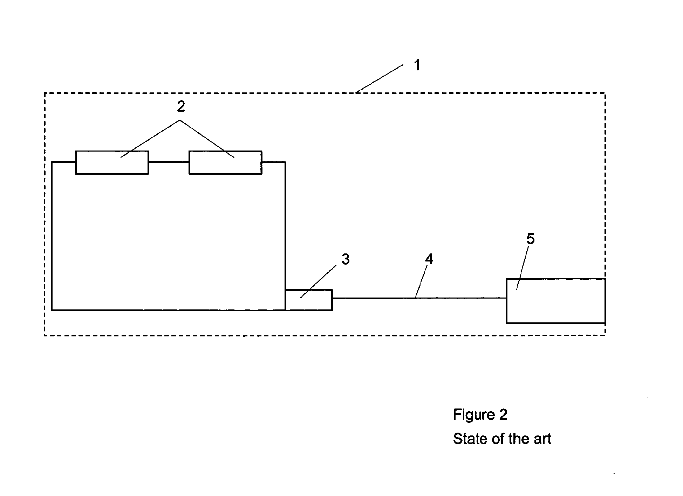

In contrary to the invention, disclosed in the description above, figure 2 shows the state of the art, in which the current and/or voltage sensing device 1 has terminals 2 and secondary terminals 3, with connected cables wires 4. The cable wires 4 ends at the evaluating unit 5.
No further consideration according to the capacitance of the cable wires is given.

### Position numbers

- 1: current and/or voltage sensing device
- 2: primary terminal / terminals
- 3: intermediate or secondary terminals
- 4: cable/wires
- 5: connector or output terminals
- 6: impedance matching element

## Claims

1. Current and/or voltage sensing device with primary and secondary circuits, for medium and/or high voltage AC - power grids, with design features, in order to cause a compensation of phase error and/or phase displacement and/or phase shift in the current and/or voltage sensing device,
**characterized in that**,
the phase displacement/error/shift is improved or minimized by impedance matching element (6), which is connected to and/or within the secondary circuit of the current and/or voltage sensing device.

2. Current and/or voltage sensing device, according to claim 1,
**characterized in that**,
the impedance matching element is located in a secondary terminal box of the current and/or voltage sensing device, wherein the shielding of the terminal box is realized by a cover layer in order to reduce external disturbances.

3. Current and/or voltage sensing device, according to claim 1,
**characterized in that**,
the impedance matching element is located in the sensing device body and/or implemented into the connecting cable, wherein the shielding of the impedance matching element is realized by a cover layer in order to reduce external disturbances.

4. Current and/or voltage sensing device, according to claim 2and/or claim 3
**characterized in that**,
the material of the cover layer is made of conductive or semiconductive material with sufficient resistance to external electrical and/or magnetic disturbances.

5. Current and/or voltage sensing device, according to claim 2 and/or claim 3
**characterized in that**,
the material of the cover layer is made of insulating material, in case the outer environment has sufficient shielding effectiveness or the use disable the possibility for significant disturbances.

6. Current and/or voltage sensing device, according to claim 1, **characterized in that**,
the impedance matching element contain at least one capacitor or at least one inductor.
